# EUROPEAN PATENT SPECIFICATION

(11) **EP 0 248 589 B1**
(45) Date of publication and mention of the grant of the patent: **03.03.1993**
(21) Application number: 87304692.4
(22) Date of filing: 27.05.1987
(51) Int. Cl.: H03L 1/02, H03B 5/36

(54) **Temperature-compensated oscillator circuit**
Temperatur-kompensierte Oszillatorschaltung
Circuit oscillateur compensé en température

(30) Priority: 28.05.1986 JP 123896/86
(43) Date of publication of application: 09.12.1987
(73) Proprietor: SEIKO ELECTRONIC COMPONENTS LTD., Sendai-shi Miyagi (JP)
(72) Inventor: Ochiai, Osamu Seiko Electronic Components, Sendai-shi Miyagi (JP); Tamura, Fujio Seiko Electronic Components, Sendai-shi Miyagi (JP)
(74) Representative: Miller, Joseph

(56) References cited:
- FR-A- 2 284 219
- FR-A- 2 466 899
- FR-A- 2 549 656
- PROCEEDINGS OF THE 40TH ANNUAL FREQUENCY SYMPOSIUM, Philadelphia, Pennsylvania, 28th-30th May 1986, pages 325-328, IEEE, New York, US; O. OCHIAI et al.: "A frequency adjustable ultra-compact, high-performance quartz crystal oscillator and its simple temperature compensation method"
- PATENT ABSTRACTS OF JAPAN, vol. 8, no. 119 (E-248)[1556], 5th June 1984; & JP-A-59 33 906 (NIPPON DENKI K.K.) 24-02-1984
- PROCEEDINGS OF 11TH INTERNATIONAL CONGRESS OF CHRONOMETRY, 1984, Besancon, pages 9-12; Y. HATTORI et al.: "Application of floating MOS variable capacitor for the watch IC"

## Description

This invention relates to temperature-compensated oscillator circuits.

Quartz crystal oscillators are widely used in various fields because of their excellent frequency stability. However, quartz crystal oscillators for mobile radio communication systems are required to have very high frequency stability, miniature size and low power consumption.

The frequency stability of a quartz crystal oscillator refers to frequency tolerance at room temperature and frequency stability versus ambient temperature.

In a highly accurate crystal oscillator circuit, the following are essential: a fine frequency adjusting means using a trimmer capacitor and a frequency-temperature compensating means for improving the frequency temperature characteristic of a quartz crystal resonator in combination with a voltage dependent electric element such as a variable capacitance diode and a temperature dependent electric element such as a thermistor. A trimmer capacitor, however, has drawbacks due to its mechanical structure, i.e. the capacitance of the trimmer capacitor is unstable if it is miniaturised and if it has a high stability it is of relatively large size. The realisation of a miniaturised highly accurate and stable quartz crystal oscillator circuit is, therefore, very difficult.

A floating gate MOS variable capacitor was recently invented and has been used in quartz crystal oscillator circuits. In this type of capacitor, the capacitance can be varied electrically by injecting electrons into the floating gate, through a thin insulating film, and hence the capacitance is kept constant after ceasing injection of electrons into the floating gate.

Details of this type of capacitor has been disclosed in the following papers: Y. Hattori and R. Matsuzaki, "Application of Floating MOS Variable Capacitor for the Watch IC", Proceedings of 11th International Congress of Chronometry, P9 to 12, 1984; and "Application of the Floating Gate MOS Variable Capacitor to the Quartz Crystal Oscillator", J.E.E., p32 to 36, December 1985. By using a variable capacitor of this type, a miniaturised highly accurate quartz crystal oscillator circuit with an electrical frequency adjustment capability has been realised. It should be noted, however, that the frequency temperature characteristic of the quartz crystal resonator itself cannot be adjusted merely by injecting electrons into the floating gate of this variable capacitor. Therefore a variable capacitance diode must in addition be provided to compensate the frequency-temperature characteristic. This results in an increase in the number of components and thus increase in size of the oscillator circuit and production costs.

The present invention seeks to provide a temperature-compensated oscillator circuit in which frequency can be adjusted electrically and frequency-temperature characteristics can be adjusted at the same time. The present invention also seeks to provide a very small size, high precision oscillator circuit. The present invention contributes to today's increasingly sophisticated needs for a reference signal source in diverse fields, such as mobile radio communication equipment.

According to one aspect of the present invention there is provided a temperature-compensated oscillator circuit including an oscillation element and a floating gate MOS variable capacitor having a three-terminal structure comprising an injection terminal (T_{I}) to which is applied a voltage for adjusting the oscillation frequency, a capacitance terminal (T_{C}) and a ground terminal (T_{G}) characterised by supply means arranged so as to supply a DC bias voltage between said capacitance terminal (T_{C}) and said ground terminal (T_{G}), said DC bias voltage being controlled, in use, according to variation in ambient temperature.

The supply means may comprise a resistor network and a fixed resistor, said bias voltage being, in operation, determined by the resistance ratio of the resistance network and the fixed resistor.

Said resistance network may comprise a thermistor and fixed resistors. Alternatively said resistance network may comprise a fixed resistor connected in series with a thermistor connected in parallel to a fixed resistor. As an alternative said resistance network may comprise a fixed resistor connected in parallel to a thermistor connected in series with a fixed resistor.

In another embodiment said oscillation element is connected through a resistor to said resistor network and the fixed resistor.

In another embodiment the temperature-compensated oscillator circuit is provided with a constant voltage circuit for providing a driving voltage to the oscillation element.

Preferably said variable capacitor has a floating electrode on the surface of a semiconductor substrate or controlling the capacitance of the variable capacitor.

The supply means may alternatively comprise a temperature-voltage converter for converting environmental temperature; an A/D converter for converting an analog output signal of the temperature-voltage converter into a digital signal; computer means for calculating the amount of frequency compensation by determining a value of DC bias voltage to be applied to a floating gate MOS variable capacitor and generating digital signals corresponding to the bias voltage; and a D/A converter for converting the digital signal from the computer means to a direct bias voltage to be applied to the variable capacitor. There may be provided with constant voltage circuit for operating the D/A converter.

The invention is illustrated, merely by way of example, in the accompanying drawings, in which:-
Figure 1 shows a block diagram of a temperature-compensated oscillator circuit according to the present invention;
Figure 2 shows a schematic sectional view of a floating gate MOS variable capacitor;
Figure 3(a) shows an equivalent electric circuit of the variable capacitor of Figure 2;
Figure 3(b) shows schematically the relation between injection voltage and capacitance of the variable capacitor of Figure 2;
Figure 4(a) shows the quartz crystal oscillator circuit with a variable capacitor which is used only for adjustment of oscillation frequency;
Figure 4(b) shows the effect of frequency adjustment to satisfy the requirement of frequency stability of an oscillator circuit with temperature change;
Figure 5(a) is a schematic view of a temperature-compensated oscillator circuit according to the present invention;
Figure 5(b) shows the relation between frequency change of the oscillator circuit and bias voltage applied to a variable capacitor of the oscillator circuit of Figure 5(a);
Figure 6(a) shows one embodiment of a temperature-compensated oscillator circuit according to the present invention;
Figures 6(b) to 6(d) are diagrams for explaining the mechanism of frequency-temperature compensation in a temperature-compensated oscillator circuit according to the present invention;
Figure 7 shows graphically the frequency-temperature characteristic of a non-temperature-compensated oscillator circuit and of a temperature-compensated oscillator circuit;
Figure 8(a) shows another embodiment of a temperature-compensated oscillator circuit according to the present invention in which a thermistor-resistor network is driven by a constant voltage circuit;
Figure 8(b) shows the voltage regulation characteristic of the constant voltage circuit of Figure 8(a);
Figures 9 and 10 show further embodiments of temperature-controlled oscillator circuits according to the present invention, in which thermistor-resistor networks are simplified for miniaturisation;
Figure 11 shows another embodiment of a temperature-compensated oscillator circuit according to the present invention in which a thermistor-resistor network is made more complex for optimisation of temperature-compensation; and
Figures 12 and 13 show yet further embodiments of temperature-compensated oscillator circuits according to the present invention in which bias voltage applied to a variable capacitor is controlled with a microcomputer.

Throughout the drawings like parts have been designated by the same reference numerals.

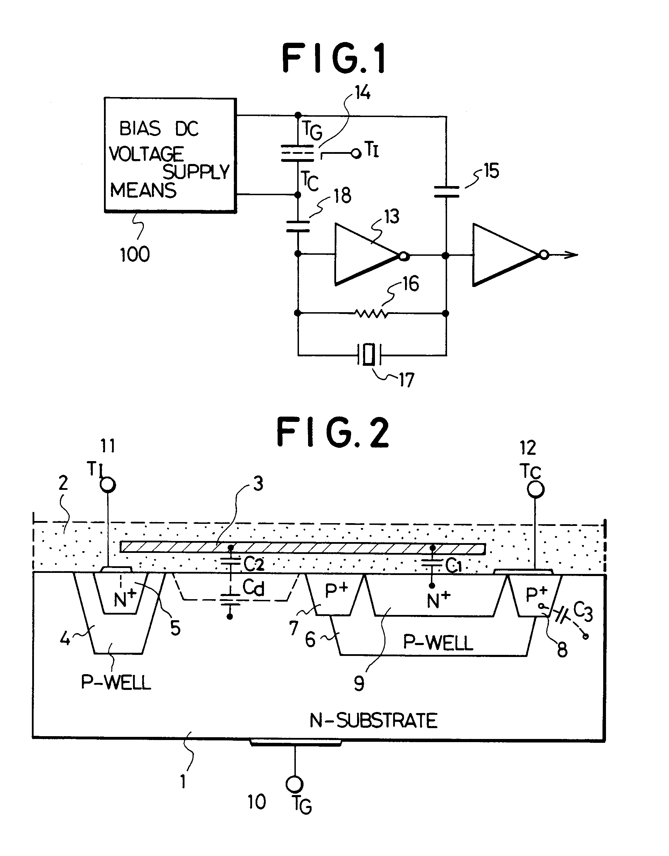

Figure 1 is a block diagram of a temperature-compensated oscillator circuit according to the present invention. The temperature-compensated oscillator circuit comprises a floating gate MOS variable capacitor 14 and a bias DC voltage supply 100. The capacitor 14 has a three-terminal structure comprising an injection terminal T_{I}, a capacitance terminal T_{C} and a ground terminal T_{G}. The oscillation frequency is adjusted by applying a voltage to the injection terminal T_{I}, and is temperature-compnsated by automatically controlling the bias DC voltage between the capacitance terminal and the ground terminal, according to variation in ambient temperature.

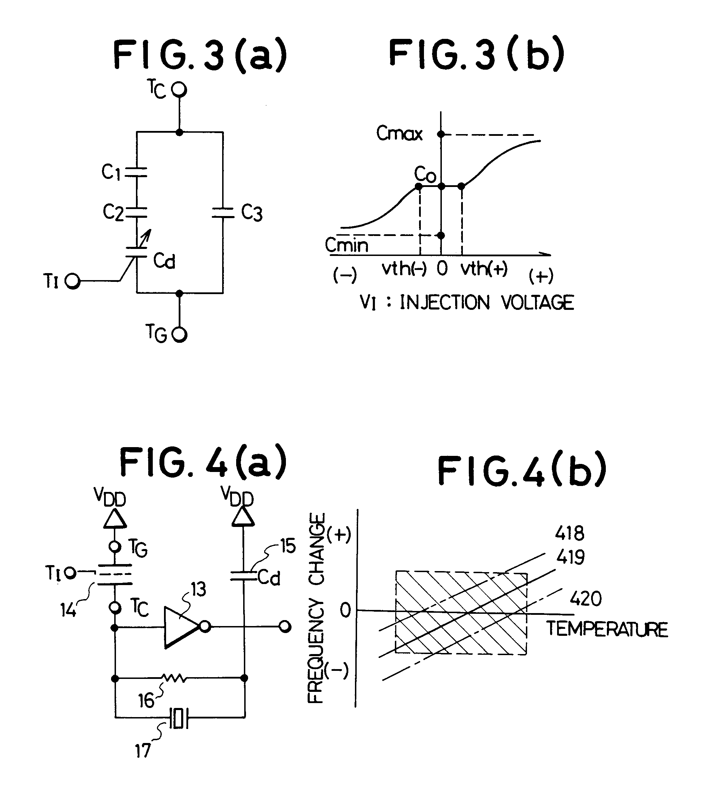

Figure 2 is a sectional view showing the structure of the floating gate MOS variable capacitor 14. Figure 3(a) shows an equivalent electric circuit of the capacitor 14. Figure 3(b) schematically shows the relation between the injection voltage and capacitance of the variable capacitor.

An N-substrate 1 of N-type silicon is formed with lowly doped P-wells 4,6, highly doped N⁺-regions 5,9, and highly doped P⁺-regions 7,8. The N-substrate 1 is covered with a silicon dioxide thin film 2 in which is buried a floating electrode 3 made of polycrystalline silicon. A ground terminal (T_{G}) 10 is connected to the back of the N-substrate 1. An injection terminal (T_{I}) 11 is connected to the N⁺-region 5 and a capacitance terminal (T_{C}) 12 is connected between the N⁺-region 9 and the P⁺-region 8. The capacitance (Cp) between the capacitance terminal 12 and the ground terminal 10 consists of: the capacitance (C₁) between the N⁺-region 9 and the floating electrode 3; the capacitance (C₂) between the upper surface of the N-substrate 1 and the floating electrode 3; the capacitance (C_{d}) of a depletion layer formed between the upper surface of the N-substrate 1 and the N-substrate 1; and the capacitance (C₃) of a depletion layer formed between the P⁺-region 8 and the N-substrate 1, as shown by the equivalent circuit of Figure 3(a). The gap between the surface of the N⁺-type region 4 and the floating electrode 3 is maintained at about 100Å. Electrons are ejected through tunnel current channels in the thin oxide film from the floating electrode 3, if a positive voltage is applied between the injection terminal 11 and the ground terminal 10 (herinafter referred to as the injection voltage). On the other hand electrons are injected if a negative injection voltage is applied. Once injected or ejected, electrons are semi-permanently retained in the floating electrode 3, even after the injection voltage is removed.

Even if no charge is injected into the floating electrode 3, an electric field is generated, due to the difference in work function between the silicon and the oxide film, between the floating electrode 3 and the upper surface of the n-substrate 1 so that the depletion layer capacitance (C_{d}) takes a certain value. At this time, the total capacitance of the capacitor takes a value C₀ (as shown in Figure 3(b)). As electrons are ejected from the floating electrode, the depletion layer to be formed below the floating electrode narrows until it disappears. As a result, the total capacitance is determined by C₁, C₂ and C₃ to approach the maximum Cₘₐₓ (as shown in Figure 3(b)). If electrons are injected into the floating electrode 3, on the other hand, the positive charge gathers in the upper surface of the N-substrate 1 so that the depletion layer spreads to reduce the capacitance C_{d}. Since before long the positive charge gathers all over the surface of the N-substrate 1, the capacitance C_{d} will not vary further even if more electrons are injected into the floating electrode 3. As a result, the total capacitance Cₚ approaches the minimum Cₘᵢₙ (as shown in Figure 3(b)). Here, in order to inject the electrons through the thin film 2, an electric field is required to have a constant intensity or more. This leaves a range (from Vth (+) to Vth (-) of Figure 3(b)), in which the total capacitance is invariable even if the injection voltage is varied.

Figure 4(a) shows an oscillation circuit having the variable capacitor of Figure 2 which is used only for frequency adjustment. The oscillator circuit has an inverter 13, the floating gate MOS variable capacitor 14, an output side load capacitor 15, a feedback resistor 16 and a quartz crystal oscillation element 17. To adjust the oscillation frequency, the capacitor 14 is, for instance, connected to the gate side of the inverter 13. The ground terminal T_{G} is connected to a positive side of a power source to provide a power supply voltage V_{DD} and the capacitance terminal T_{C} is connected to the gate of the inverter 13.

An injection voltage V_{I} is applied between the injection terminal T_{I} and the power supply voltage V_{DD}. Since the capacitance can be made larger than the constant value C₀, by ejected electrons as has been described above, the oscillation frequency can be reduced. On the other hand, the oscillation frequency can be increased by injecting electrons.

The effect of frequency adjustment is explained in Figure 4(b). In Figure 4(b), a hatched zone is one satisfying a predetermined frequency-temperature standard, and straight lines 418,420 do not satisfy that zone, but can be changed to a straight line 419 by changing the injection voltage of the variable capacitor. However, in an oscillator circuit having a not so excellent frequency-temperature characteristic as represented by the line 419, the margin to the predetermined frequency temperature characteristic cannot be enlarged only by adjusting the frequency, but can be enlarged by changing the frequency-temperature characteristic itself. This is the reason that the frequency-temperature compensation is required.

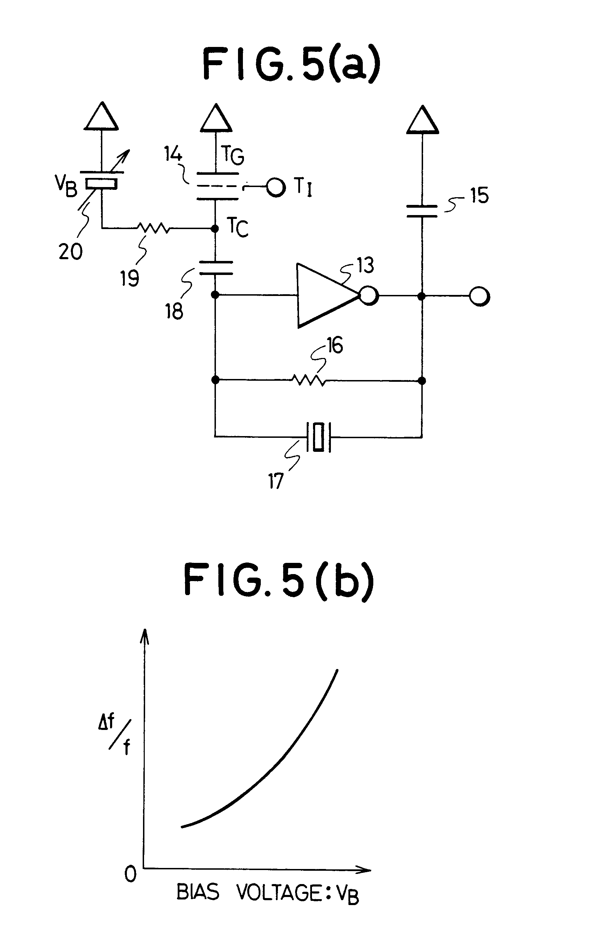

Figure 5(a) shows a schematic circuit diagram to explain the principle of a temperature-compensated oscillator circuit according to the present invention. A DC bias voltage is applied to the capacitance terminal T_{C} via a resistor 19. Figure 5(b) shows the relation between bias voltage V_{B} and change in oscillation frequency. A capacitor 18 is provided for cutting off DC current and the resistor 19 blocks any high frequency signal from the power source. As shown in Figure 3(a), the capacitance C₃ denotes the depletion layer capcitance of the parastic diode formed between the capacitance terminal T_{C} (P⁺-region) and the ground terminal T_{G} (N-region) of the variable capacitor 14. The capacitance C₃ can be changed by varying the bias voltage V_{B} applied between the capacitance terminal T_{C} and the ground terminal T_{G}. In this example, when the bias voltage V_{B} is raised, the depletion layer capacitance C₃ is reduced and the oscillation frequency is increased as shown in Figure 5(b).

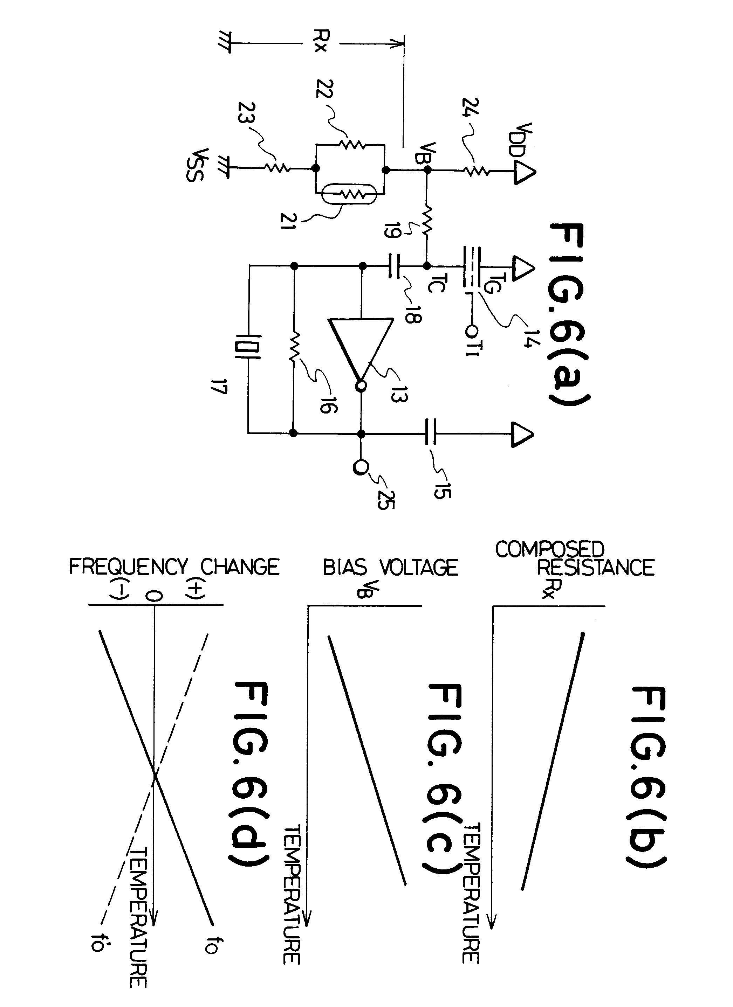

Figure 6(a) shows one embodiment of a temperature-compensated oscillator circuit according to the present invention and Figures 6(b) to 6(d) are diagrams for explaining the operation thereof. In Figure 6(a) a thermistor 21 has a negative temperature coefficient. The oscillator circuit has a resistor 22 for relaxing the resistance-temperature characteristic of the thermistor, and resistors 23,24 are provided for properly determining the bias voltage V_{B} together with the thermistor and the resistor 22. Reference Rₓ denotes the combined resistance of the thermistor 21 and the resistors 22,23. As shown in Figure 6(b), the resistance of the thermistor 21 falls with rise of ambient temperature so that the combined resistance Rₓ drops. At this time, the bias voltage V_{B} increases with rise of ambient temperature, as shown in Figure 6(c), with reference to the power supply voltage V_{DD}. As a result, the total capacitance Cₚ of the variable capacitor drops, but the oscillation frequency increases, as shown by solid lines fʹ₀ in Figure 6(d). Therefore, if the frequency-temperature characteristic of the quartz crystal oscillation element 17 is that indicated by broken line f₀ in Figure 6(b), the frequency of the output signal of an output terminal 25 of the oscillation circuit shown in Figure 6(a) does not vary with variation of ambient temperature, i.e. the oscillation frequency has been compensated. According to this embodiment of the present invention, as the bias voltage to the capacitance terminal of the variable capacitor automatically varies in accordance with the ambient temperature, total capacitance Cₚ of the variable capacitor varies, and thus oscillation frequency is compensated substantially independently of frequency adjustment using a single floating gate MOS variable capacitor.

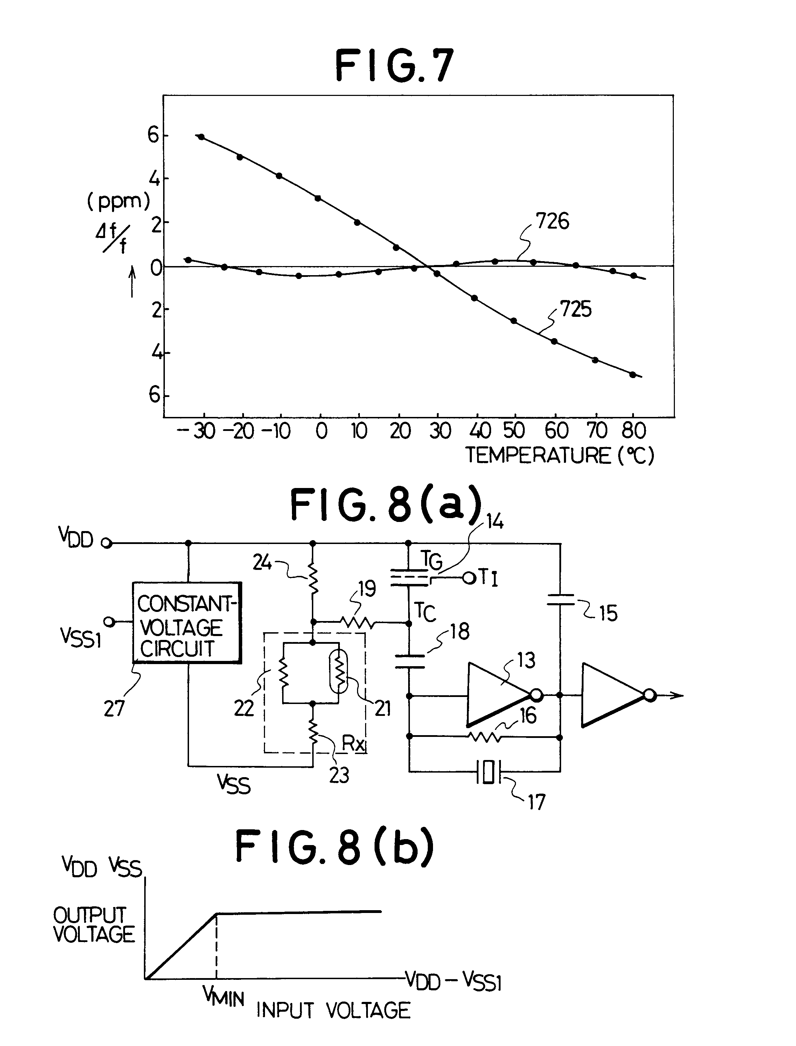

Figure 7 shows an example of the measured temperature characteristics of the oscillation frequency in the temperature-controlled oscillator circuit of Figure 6(a). In this embodiment: R₂₂ = 15 K ohms; R₂₃ = 33 K ohms; R₂₄ = 15 K ohms; R₁₉ = 47 K ohms; C₁₅ = 15 pF; C₁₈ = 200 pF; R₁₆ = 5 M ohms; V_{DD} = 1.85 V; and the quartz crystal oscillation element 17 is a GT-cut oscillation element of 2.1 MHz. In Figure 7, a curve 725 shows the temperature characteristics of the frequency of the oscillator circuit before temperature-compensation, and a curve 726 shows the temperature characteristics of the oscillation frequency when the temperature-compensation is conducted. In the embodiment of Figure 6(a), there is presented a method of temperature-compensation in the case where the temperature coefficient of the frequency of the quartz crystal oscillation element before temperature compensation is negative (that is, the frequency decreases in accordance with increase in temperature). When the frequency temperature coefficient of the quartz crystal oscillation element before temperature-compensation is positive (that is, the frequency increases in accordance with increase in temperature), it is quite apparent from the description of Figure 5 that the temperature-compensation can be accomplished in similar manner by connecting the resistor 24 to the negative power supply voltage V_{SS} and connecting the combined resistance Rₓ to the power supply voltage V_{DD} as shown in Figure 6(a).

Figure 8 shows another embodiment of a temperature-compensated oscillator circuit according to the present invention. A constant voltage circuit 27 is connected between the power supply voltages V_{DD} and V_{SS1} to generate a power supply voltage V_{DD} - V_{SS} for the oscillation circuit. Figure 8(b) schematically shows the relation between the output voltage V_{DD} - V_{SS} and input voltage V_{DD} - V_{SS1} of the constant voltage circuit. For an input voltage higher than Vₘᵢₙ, the output voltage V_{DD} - V_{SS} is invariable even if the input voltage V_{DD} - V_{SS1} varies. As a result, as shown in Figure 8(a), the bias voltage V_{B} of the variable capacitor 14 remains constant even if the power supply voltage V_{DD} - V_{SS1} varies, so that neither the oscillation frequency nor the frequency temperature characteristic varies. This is important for implementing the frequency temperature-compensation.

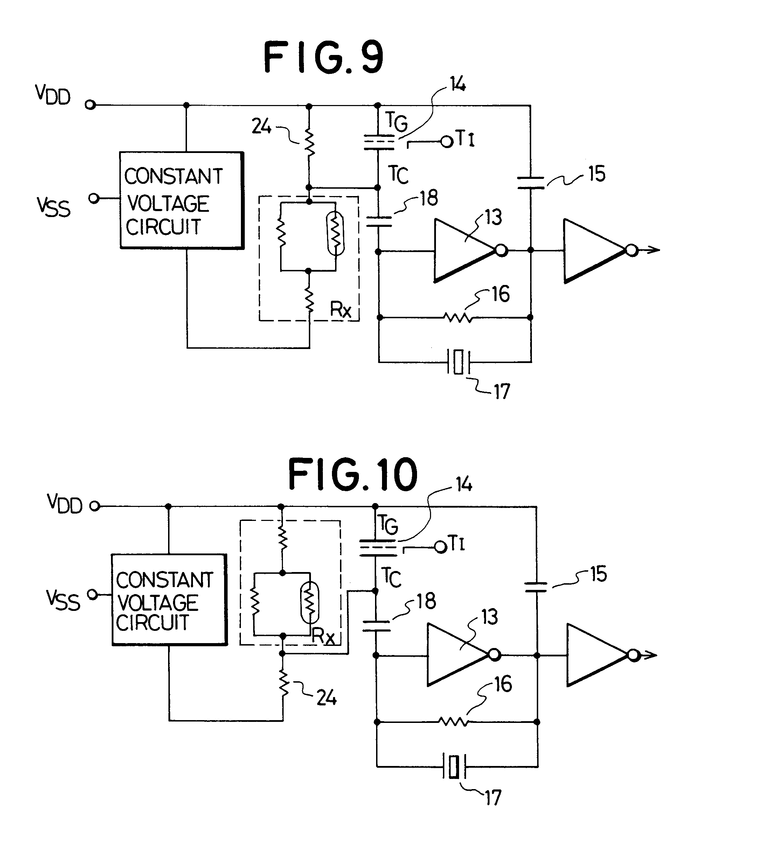

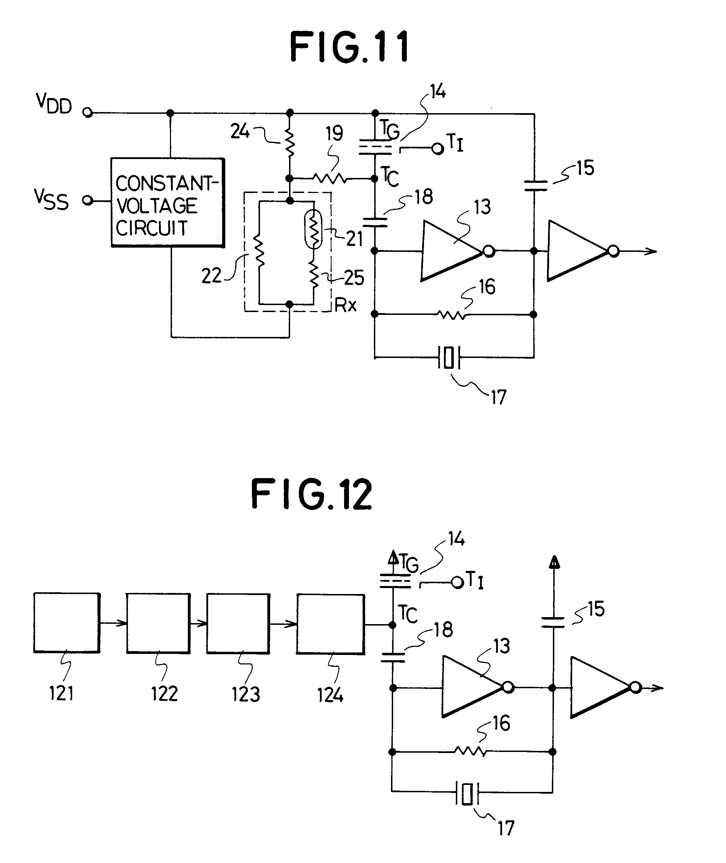

Figures 9, 10 and 11 show further embodiments of temperature-compensated oscillator circuits according to the present invention. In Figure 9 the oscillator circuit is directly connected to the combined resistance Rₓ and the fixed resistor 24, i.e. being not connected through the resistor 19. In this circuit, as temperature rises, the bias voltage of the variable capacitor 14 will increase, and oscillation frequency will increase. Therefore, temperature characteristics of the quartz crystal oscillation element 17 with a primary negative temperature coefficient can be compensated. On the other hand, in Figure 10, temperature characteristics of the quartz temperature oscillation element 17 with a primary positive temperature coefficient can be compensated. Moreover, the combined resistance Rₓ includes the fixed resistor 22 connected in parallel to the thermistor 21 connected in series with a fixed resistor 30 as shown in Figure 11.

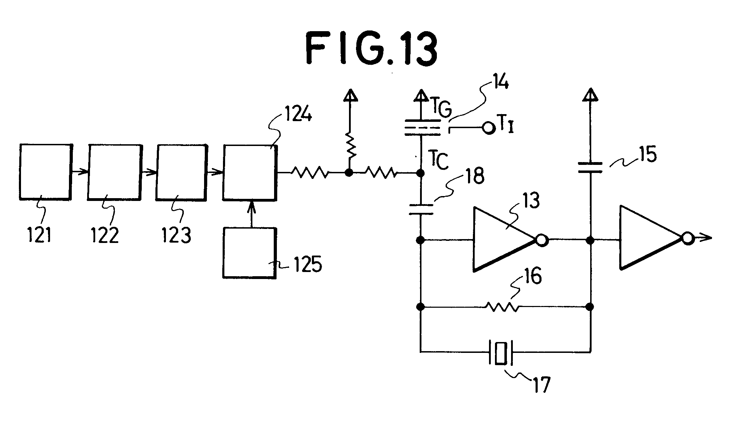

Further embodiments of temperature-compensated oscillator circuits according to the present invention are illustrated in Figures 12 and 13. As shown in Figure 12, the temperature-compensated oscillator circuit includes a temperature-voltage converter 121 for converting ambient or environmental temperature into a direct bias voltage, an A/D converter 122 for converting an analog output signal of the temperature-voltage converter into a digital signal, a microcomputer 123 which calculates the amount of frequency compensation and determines a necessary value DC bias voltage to be applied to the variable capacitor 14 and generates a digital signal corresponding to the bias voltage, and a D/A converter 124 for converting the digital signal generated by the microcomputer into an analog direct bias voltage signal to be applied to the variable capacitor 14. In Figure 13, the reference numeral 125 denotes a constant-voltage circuit for operating the D/A converter 124. The DC bias voltage applied to the terminal T_{C} of the variable capacitor 14 is calculated in the microcomputer based on the reference values stored in it in advance.

In the above described embodiment of temperature-compensated oscillation circuits according to the present invention the temperature-compensation of oscillation frequency can be executed remarkably easily by using a floating gate MOS variable capacitor which can have its capacitance electrically varied when electric charge is injected into the floating electrode and by varying another depletion layer capacitance of the parasitic diode of the variable capacitor automatically in accordance with ambient temperature with a thermistor-resistor network. Since both frequency adjustment and frequency temperature characteristic adjustments can be performed by a single variable capacitor without using a variable capacitance diode, there is achieved miniaturised high accuracy quartz crystal oscillator circuits which have high frequency accuracy and minimum change in frequency due to temperature. By stabilising the power source voltage, moreover, it is possible to provide an oscillator circuit which has its oscillation frequency and frequency temperature characteristic invariable even if the power supply voltage fluctuates.

## Claims

1. A temperature-compensated oscillator circuit including an oscillation element (17) and a floating gate MOS variable capacitor (14) having a three-terminal structure comprising an injection terminal (T_{I}) to which is applied a voltage for adjusting the oscillation frequency, a capacitance terminal (T_{C}) and a ground terminal (T_{G}) characterised by supply means (100) arranged so as to supply a DC bias voltage between said capacitance terminal (T_{C}) and said ground terminal (T_{G}), which DC bias voltage is controlled according to variation in ambient temperature.

2. A temperature-compensated oscillator circuit as claimed in claim 1 characterised in that supply means (100) comprises a resistor network (21,22,23) and a fixed resistor (24) said bias voltage being, in operation, determined by the resistance ratio of the resistance network and the fixed resistor.

3. A temperature-compensated oscillator circuit as claimed in claim 2 characterised in that said resistance network comprises a thermistor (21) and fixed resistors (22,23).

4. A temperature-compensated oscillator circuit as claimed in claim 2 characterised in that said resistor network comprises a fixed resistor (30) connected in series with a thermistor (21) connected in parallel to a fixed resistor (22).

5. A temperature-compensated oscillator circuit as claimed in claim 2 characterised in that said resistor network comprises a fixed resistor (22) connected in parallel to a thermistor (21) connected in series with a fixed resistor (23).

6. A temperature-compensated oscillator circuit as claimed in claim 2 characterised in that said oscillation element (17) is connected through a resistor (19) to said resistor network (21,22,23) and the fixed resistor (24).

7. A temperature-compensated oscillator circuit as claimed in any preceding claim characterised by a constant voltage circuit (27) for providing a driving voltage to the oscillation element (17).

8. A temperature-compensated oscillator circuit as claimed in any preceding claim characterised in that said variable capacitor (14) has a floating electrode (13) on the surface of a semiconductor substrate (1) for controlling the capacitance of the variable capacitor.

9. A temperature-compensated oscillator circuit as claimed in claim 1 characterised in that supply means comprises: a temperature-voltage converter (121) for converting environmental temperature; an A/D converter (122) for converting an analog output signal of the temperature-voltage converter (121) into a digital signal; computer means (123) for calculating the amount of frequency compensation by determining a value of DC bias voltage to be applied to a floating gate MOS variable capacitor (14) and generating digital signals corresponding to the bias voltage; and a D/A converter (124) for converting the digital signal from the computer means (123) to a direct bias voltage to be applied to the variable capacitor (14).

10. A temperature-compensated oscillator circuit as claimed in claim 9 characterised by a constant voltage circuit (125) for operating the D/A converter (124).

## Patentansprüche

1. Temperaturkompensierte Oszillatorschaltung mit einem Oszillatorelement (17) und einem drei Anschlüsse aufweisenden variablen Floating Gate-MOS-Kondensator (14) mit einem Injektionsanschluß (T_{I}), an dem eine Spannung zur Einstellung der Oszillatorfrequenz liegt, einem Kondensatoranschluß (T_{C}) und einem Erdanschluß (T_{G}), **gekennzeichnet durch** eine Spannungsquelle (100) zur Einspeisung einer Gleichspannung zwischen dem Kapazitätsanschluß (T_{C}) und dem Erdanschluß (T_{G}), welche in Abhängigkeit von Umgebungstemperaturänderungen gesteuert wird.

2. Temperaturkompensierte Oszillatorschaltung nach Anspruch 1, **dadurch gekennzeichnet,** daß die Spannungsquelle (100) ein Widerstandsnetzwerk (21, 22, 23) und einen festen Widerstand (24) umfaßt und daß die Vorspannung im Betrieb durch das Widerstandsverhältnis des Widerstandsnetzwerkes und des festen Widerstandes festgelegt ist.

3. Temperaturkompensierte Oszillatorschaltung nach Anspruch 2, **dadurch gekennzeichnet,** daß das Widerstandsnetzwerk einen Thermistor (21) und feste Widerstände (22, 23) umfaßt.

4. Temperaturkompensierte Oszillatorschaltung nach Anspruch 2, **dadurch gekennzeichnet,** daß das Widerstandsnetzwerk eine Reihenschaltung eines festen Widerstandes (30) und eines Thermistors (21), die einem festen Widerstand (22) parallel geschaltet sind, umfaßt.

5. Temperaturkompensierte Oszillatorschaltung nach Anspruch 2, **dadurch gekennzeichnet,** daß das Widerstandsnetzwerk eine Parallelschaltung eines festen Widerstandes (22) und eines Thermistors (21), die in Serie zu einem festen Widerstand (23) liegen, umfaßt.

6. Temperaturkompensierte Oszillatorschaltung nach Anspruch 2, **dadurch gekennzeichnet,** daß das Oszillatorelement (17) über einen Widerstand (19) an das Widerstandsnetzwerk (21, 22, 23) und den festen Widerstand (24) geschaltet ist.

7. Temperaturkompensierte Oszillatorschaltung nach den vorhergehenden Ansprüchen, **gekennzeichnet durch** eine Konstantspannungsschaltung (27) zur Erzeugung einer Treiberspannung für das Oszillatorelement (17).

8. Temperaturkompensierte Oszillatorschaltung nach den vorhergehenden Ansprüchen, **dadurch gekennzeichnet,** daß der variable Kondensator (14) eine floatende Elektrode (13) auf der Oberfläche eines Halbleitersubstrats (1) zur Steuerung seiner Kapazität besitzt.

9. Temperaturkompensierte Oszillatorschaltung nach Anspruch 1, **dadurch gekennzeichnet,** daß die Spannungsquelle folgende Komponenten umfaßt: einen Temperatur-Spannungs-Umsetzer (121) zur Umsetzung der Umgebungstemperatur; einen A/D-Umsetzer (122) zur Umsetzung eines analogen Ausgangssignals des Temperatur-Spannungs-Umsetzers (121) in ein Digitalsignal; eine Computeranordnung (123) zur Berechnung des Betrages der Frequenzkompensation durch Festlegung eines Wertes der in einen variablen Floating Gate-MOS-Kondensator (14) und Erzeugung von Digitalsignalen entsprechend der Vorspannung; und einen D/A-Umsetzer (124) zur Umsetzung des Digitalsignals von der Computeranordnung (123) in eine in den variablen Kondensator (14) einzuspeisende Gleichvorspannung.

10. Temperaturkompensierte Oszillatorschaltung nach Anspruch 9, **gekennzeichnet durch** eine Konstantspannungsschaltung (125) zum Betrieb des D/A-Umsetzers (124).

## Revendications

1. Un circuit oscillateur compensé en température comprenant un élément oscillant (17) et un condensateur variable MOS à grille flottante (14) ayant une structure à trois bornes qui comprend une borne d'injection (T_{I}) à laquelle on applique une tension dans le but de régler la fréquence d'oscillation, une borne de capacité (T_{C}) et une borne de masse (T_{G}), caractérisé par des moyens d'alimentation (100) qui sont conçus de façon à appliquer une tension de polarisation continue entre la borne de capacité (T_{C}) et la borne de masse (T_{G}), cette tension de polarisation continue étant commandée conformément à la variation de la température ambiante.

2. Un circuit oscillateur compensé en température selon la revendication 1, caractérisé en ce que les moyens d'alimentation (100) comprennent un réseau de résistances (21, 22, 23) et une résistance fixe (24), la tension de polarisation étant déterminée, pendant le fonctionnement, par le rapport de résistance du réseau de résistances et de la résistance fixe.

3. Un circuit oscillateur compensé en température selon la revendication 2, caractérisé en ce que le réseau de résistances comprend une thermistance (21) et des résistances fixes (22, 23).

4. Un circuit oscillateur compensé en température selon la revendication 2, caractérisé en ce que le réseau de résistances comprend une résistance fixe (30) connectée en série avec une thermistance (21) qui est connectée en parallèle avec une résistance fixe (22).

5. Un circuit oscillateur compensé en température selon la revendication 2, caractérisé en ce que le réseau de résistances comprend une résistance fixe (22) qui est connectée en parallèle avec une thermistance (21) connectée en série avec une résistance fixe (23).

6. Un circuit oscillateur compensé en température selon la revendication 2, caractérisé en ce que l'élément oscillant (17) est connecté par l'intermédiaire d'une résistance (19) au réseau de résistances (21, 22, 23) et à la résistance fixe (24).

7. Un circuit oscillateur compensé en température selon l'une quelconque des revendications précédentes, caractérisé par un circuit à tension constante (27) qui est destiné à appliquer une tension d'attaque à l'élément oscillant (17).

8. Un circuit oscillateur compensé en température selon l'une quelconque des revendications précédentes, caractérisé en ce que le condensateur variable (14) comporte une électrode flottante (13) sur la surface d'un substrat semiconducteur (1), pour commander la capacité du condensateur variable.

9. Un circuit oscillateur compensé en température selon la revendication 1, caractérisé en ce que les moyens d'alimentation comprennent : un convertisseur température-tension (121) qui est destiné à convertir la température ambiante; un convertisseur A/N (122) qui est destiné à convertir en un signal numérique un signal de sortie analogique du convertisseur température-tension (121); des moyens à ordinateur (123) qui sont destinés à calculer la valeur de compensation de fréquence, en déterminant la valeur de la tension de polarisation continue qui doit être appliquée à un condensateur variable MOS à grille flottante (14) et à générer des signaux numériques correspondant à la tension de polarisation; et un convertisseur N/A (124) qui est destiné à convertir le signal numérique provenant des moyens à ordinateur (123), pour donner une tension de polarisation continue à appliquer au condensateur variable (14).

10. Un circuit oscillateur compensé en température selon la revendication 9, caractérisé par un circuit à tension constante (125) qui est destiné à faire fonctionner le convertisseur N/A (124).
